# EUROPEAN PATENT SPECIFICATION

(11) **EP 3 948 138 B1**
(45) Date of publication and mention of the grant of the patent: **12.11.2025**
(21) Application number: 20783602.4
(22) Date of filing: 03.04.2020
(51) Int. Cl.: F28F 3/12, F28F 3/08, C09K 5/02, F28F 3/04, F28D 15/00, H05K 7/20, F25D 11/00, F25D 3/06

(54) **THERMAL MANAGEMENT DEVICES AND METHODS**
WÄRMEVERWALTUNGSVORRICHTUNGEN UND -VERFAHREN
DISPOSITIFS ET PROCÉDÉS DE GESTION THERMIQUE

(30) Priority: 05.04.2019 US 201962829691 P
(43) Date of publication of application: 09.02.2022
(73) Proprietor: Phase Change Energy Solutions, Inc., Asheboro NC North Carolina 27203 (US)
(72) Inventor: SAWAFTA, Reyad, I., Greensboro, NC 27410 (US); OWENS, Byron, Craig, Asheboro, NC 27203 (US)
(74) Representative: HGF
(86) International application number: PCT/US2020/026743
(87) International publication number: WO 2020/206371

(56) References cited:
- EP-A1- 2 094 069
- WO-A1-2017/040591
- WO-A1-93/05348
- CN-U- 206 905 596
- DE-A1- 102011 075 462
- KR-B1- 100 451 916
- KR-B1- 101 371 362
- US-A1- 2007 204 645
- US-A1- 2016 006 088
- US-A1- 2018 166 754
- US-B2- 6 581 402
- US-B2- 7 836 722
- US-B2- 8 689 861
- ANONYMOUS: "Brazed Plate Heat Exchanger", 14 May 2017 (2017-05-14), pages 1 - 32, XP055745413, Retrieved from the Internet <URL:https://www.kaori-bphe.com/uploads/editor/files/Catalogue_EN_Imperial-Unit.pdf> [retrieved on 20200607]

## Description

### FIELD

The present disclosure relates to devices and methods for managing temperature, and, in particular, devices and methods for cooling or maintaining a desired temperature of a room or storage space.

### BACKGROUND

In recent years, business owners have sought to reduce energy consumption and costs associated with managing or maintaining the temperature of interior spaces or buildings, such as data centers, storage rooms, freezers, refrigeration rooms, or other storage spaces. Various devices and systems have been implemented for this purpose. However, many existing devices and systems suffer from one or more disadvantages. For example, some devices and systems address only the thermal insulation of a storage space from outdoor temperatures. In addition, many devices and systems require permanent and/or expensive installation within a room or other space. For example, many systems rely on active temperature management methods and systems that require continuous electrical energy use and/or complex and expensive air handling systems. As a result, many existing devices and systems fail to provide rapid recouping of their initial cost and/or require substantial retrofitting or refurbishment of space in which they are used. The high cost and/or effort of installing and using some previous devices and systems can also hinder the widespread adoption of such devices and systems in businesses. Hence, improved devices and methods for managing the temperature of a room or other space are needed. WO 93/05348 discloses a vacuum panel heat exchanger including an evaporator and a condenser, and KR 100451916 discloses a cooling apparatus using a thin pipe configuration. US 2016/006088 A for example discloses a thermal management plate according to the preamble of claim 1.

### SUMMARY

The invention is defined in the claims.

In some embodiments, a thermal energy management device described herein can be used to provide thermal energy management (e.g., cooling or other temperature maintenance) for interior spaces or buildings, such as data centers, telecommunications (telecom) shelters, data storage or other storage rooms, freezers, refrigeration rooms, or other storage spaces, including in a manner that is modular, cost-effective, and easily-installed.

In some embodiments, a thermal management device described herein comprises a plate or panel or has the form or shape of a plate or panel. The plate or panel comprises an exterior surface defining an interior or internal volume. The thermal management plate can further comprise a thermal management material disposed within the interior volume and a fill spout in fluid communication with the interior volume and an external environment of the plate. In some embodiments, the plate has a generally polyhedral shape. For example, in some cases, the exterior surface of the plate has a front side, a back side, and at least four corners. The fill spout of the plate, in some preferred embodiments, is disposed at one of the corners of the exterior surface.

Additionally, in some instances, the front side and back side of the plate each independently has a total length less than 40 inches and a total width less than 80 inches. In some cases, the front side and back side can independently have a total length between 12 and 24 inches and a total width between 20 and 40 inches. Further, in some embodiments, the plate can have a thickness or average thickness of less than 6 inches, less than 3 inches, or less than 2 inches.

In some embodiments, the exterior surface further comprises one or more protrusions extending in an orthogonal direction from the back side. The one or more protrusions can form a gap between the back side and an adjacent surface that is operable to ventilate or otherwise permit air flow or provide a gap adjacent to the back side of the plate. In still further embodiments, the exterior surface can further comprise one or more channels, through holes, or perforations extending from the front side to the back side and connecting the front side to the back side.

Additionally, in some cases, the thermal management plate is filled with a thermal management material. For example, a thermal management material can include a phase change material (PCM). In some cases, at least 97% of the interior volume is occupied by the thermal management material. In other cases, the thermal management material comprises 70-95% or by volume of the plate. The thermal management material, in some embodiments, has a phase transition temperature between -50°C and 150°C, a phase transition temperature between -10°C and 10°C, between 0°C and 10°C, between 2°C and 8°C, between 20°C and 50°C, between 20°C and 30°C, or between 50°C and 90°C.

In still further embodiments, the plate can further comprise a cap, which, in some cases, is a snap-on cap or a screw-on cap. The surfaces of the cap, in some embodiments, align with the aforementioned exterior surface of the plate to conceal the corner fill spout. In other embodiments, the plate further comprises a fan, which, in some cases, is positioned within a channel, through hole, or perforation. The fan, in some cases, is thermoelectrically powered or solar powered.

In another aspect, methods of managing temperature and/or methods of cooling are described herein. Any one or more devices, as described herein, can be used in any one or more methods of managing temperature or methods of cooling described herein. In some embodiments, methods of cooling a data center, telecom shelter, or data storage room (or other space) are described. The method, in some embodiments, comprises disposing one or more thermal management devices, as described herein, in an interior of the data center or data storage room (or other space). In further embodiments, the method includes positioning the one or more devices so the back surface of the device faces a wall of the data center or room or other space (e.g., the back of the device faces the closest wall to the device), and suspending or hanging the one or more devices from the wall. In some cases, the one or more devices are suspended from, attached to, snapped into, or slide into a mounting mechanism (such as a rail or a set of parallel rails) positioned on the wall.

In another embodiment, methods of cooling a pallet, box, shipper, or container are described herein. The method, in some cases, comprises providing one or more thermal management devices, as described herein, and positioning the one or more devices in an interior space of the pallet (or box, shipper, or other container), such as on the bottom of the pallet (or box, shipper, or other container). In some cases, the method further comprises providing a fan and positioning the fan in the interior space of the pallet. The fan, in some cases, is positioned within a channel of the one or more devices.

These and other embodiments are described in greater detail in the detailed description that follows.

### BRIEF DESCRIPTION OF THE DRAWINGS

Figure 1A is a perspective view of the front side of a thermal management plate according to a first example embodiment.
Figure 1B is a side view of the thermal management plate according to a first example embodiment.
Figure 1C is a perspective view of the back side of a thermal management plate according to a first example embodiment.
Figure 1D is a side view of the back side of a thermal management plate according to a first example embodiment.
Figure 1E is a side view of the thermal management plate according to a first example embodiment.
Figure 1F is a side view of the thermal management plate according to a first example embodiment.
Figure 1G is a top plan view of the thermal management plate according to a first example embodiment.
Figure 1H is a bottom view of the thermal management plate according to a first example embodiment.
Figure 1I is a perspective view of a fill spout of the thermal management plate according to a first example embodiment.
Figure 1J is a perspective view of a fill spout of the thermal management plate according to a first example embodiment.
Figure 2A is a perspective view of the front side of a thermal management plate according to a second example embodiment.
Figure 2B is a perspective view of the back side of a thermal management plate according to a second example embodiment.
Figure 2C is a sectioned perspective view of the interior or internal volume of a thermal management plate according to a second example embodiment.
Figure 3A is a perspective view of the back side of a thermal management plate according to a third example embodiment.
Figure 3B is a sectioned perspective view of the interior or internal volume of a thermal management plate according to a third example embodiment.
Figure 4A is a perspective view of the back side of a thermal management plate according to a fourth example embodiment.
Figure 4B is a sectioned perspective view of the interior or internal volume of a thermal management plate according to a fourth example embodiment.
Figure 5A is a perspective view of the front side of a thermal management plate according to a fifth example embodiment.
Figure 5B is a sectioned perspective view of the fill spout of a thermal management plate according to a fifth example embodiment.
Figure 5C is a sectioned perspective view of the interior or internal volume of a thermal management plate according to a fifth example embodiment.
Figure 6 is a perspective view of a stack of thermal management plates according to a sixth example embodiment.
Figure 7A is a perspective view of a cap for a thermal management plate according to one embodiment described herein.
Figure 7B is a perspective view of a cap for a thermal management plate according to one embodiment described herein.
Figure 7C is a side view of a cap for a thermal management plate according to one embodiment described herein.
Figure 7D is a bottom view of a cap for a thermal management plate according to one embodiment described herein.
Figure 7E is a side view of a cap positioned over a fill spout of a thermal management plate according to one embodiment described herein.

### DETAILED DESCRIPTION

Embodiments described herein can be understood more readily by reference to the following detailed description and figures. Devices and methods described herein, however, are not limited to the specific embodiments presented in the detailed description, examples, and figures. It should be recognized that these embodiments are merely illustrative of the principles of the present invention. Numerous modifications and adaptations will be readily apparent to those of skill in the art within the scope of the invention as defined in the claims.

In addition, all ranges disclosed herein are to be understood to encompass any and all subranges subsumed therein. For example, a stated range of "1.0 to 10.0" should be considered to include any and all subranges beginning with a minimum value of 1.0 or more and ending with a maximum value of 10.0 or less, e.g., 1.0 to 5.3, or 4.7 to 10.0, or 3.6 to 7.9. Similarly, it is understood that a stated range of "1 to 10" should be considered to include any and all subranges beginning with a minimum value of 1 or more and ending with a maximum value of 10 or less, e.g., 1 to 6, 2 to 10, 3 to 5, or 7 to 9.

All ranges disclosed herein are also to be considered to include the end points of the range, unless expressly stated otherwise. For example, a range of "between 5 and 10" or "from 5 to 10" or "5-10" should generally be considered to include the end points 5 and 10.

Further, when the phrase "up to" is used in connection with an amount or quantity, it is to be understood that the amount is at least a detectable amount or quantity. For example, a material present in an amount "up to" a specified amount can be present from a detectable amount and up to and including the specified amount.

### I. Thermal Management Devices

In one aspect, thermal management devices are described herein. In some embodiments, the thermal management device is a thermal management plate (or panel) comprising an exterior surface defining an interior volume, and a thermal management material disposed within the interior volume. Additionally, the plate includes a fill spout. The fill spout (when in an open configuration, as opposed to a closed or sealed configuration) provides fluid communication between the interior volume and the external environment of the plate. The exterior surface of the plate includes a front side, a back side, and at least four corners. The fill spout is disposed at one of the corners of the exterior surface. The plate can have a generally polyhedral shape, and the specific shape of the plate is not particularly limited.

For example, in some embodiments, the plate can be generally square or rectangular in cross section (e.g., such that the plate is a relatively short or "flat" rectangular cylinder). Moreover, in certain preferred embodiments, the plate has a relatively high surface area to volume ratio. For example, in some cases, the plate can have a surface area to volume ratio (e.g., in units of cm²/cm³) of at least 1:2, at least 1:3, at least 1:4, at least 1:5, at least 1:10, at least 1:20, at least 1:50, or at least 1:100. In some embodiments, the plate has a surface area to volume ratio between about 1:3 and 1:100, between about 1:3 and 1:50, between about 1:5 and 1:100, between about 1:5 and 1:50, or between about 1:10 and about 1:100. Similarly, in some cases, the average thickness of the plate can be relatively small compared to the average length and average width of the plate. For instance, in some embodiments, the average length and the average width of the plate are at least 5 times, at least 10 times, at least 20 times, or at least 50 times the average thickness of the plate. In some cases, the average length and the average width of the plate are 5-100, 5-50, 5-20, 10-100, or 10-50 times the average thickness of the plate.

Moreover, in some preferred implementations, the exterior surface of the plate further comprises one or more protrusions. The protrusions extend in an orthogonal or substantially orthogonal (e.g., within 15 degrees, within 10 degrees, or within 5 degrees of orthogonal) direction from the back side of the plate. As further described herein, in some cases, the one or more protrusions are configured or operable to form a gap between the back side of the plate and an adjacent surface, such as a wall against which the plate is disposed or another plate with which the plate is stacked. The protrusions can thus act as a spacer.

In addition, in some especially preferred embodiments, the exterior surface of the plate further comprises one or more channels extending from the front side to the back side and connecting the front side to the back side. These channels may also be described as through holes or perforations of the plate.

Further, in some preferred embodiments, a plate described herein also comprises a cap. More particularly, such a cap can cover, enclose, or "complete" the corner where the fill spout is disposed. Thus, in some cases, for instance, surfaces of the cap align with the exterior surface of the plate to conceal the corner fill spout.

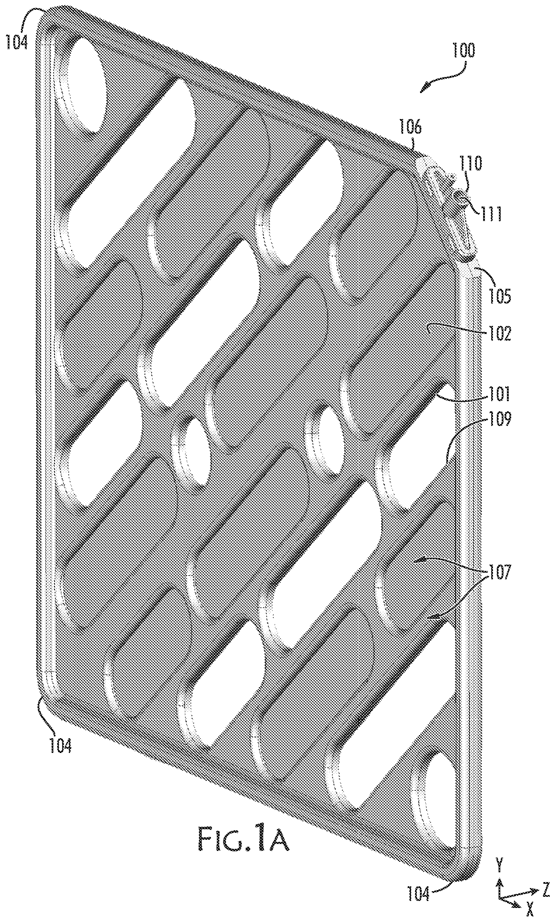

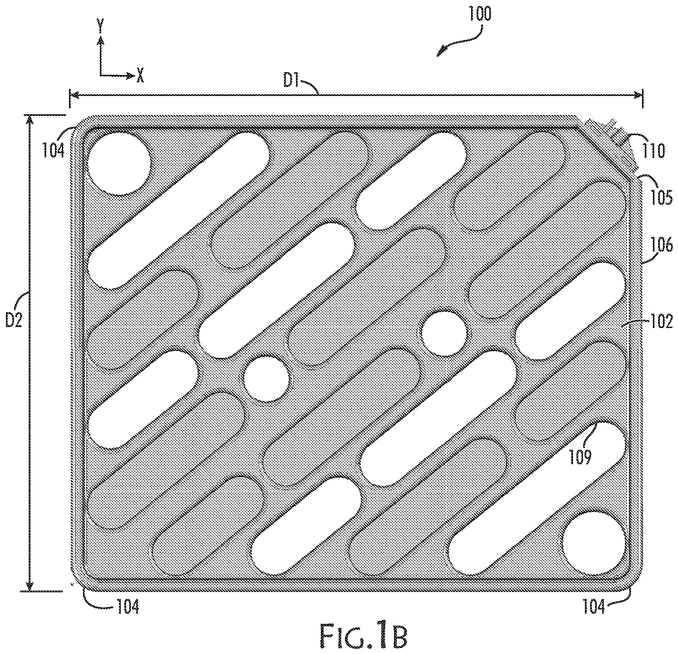

Further details regarding the configuration, operation, and use of devices described herein are provided below, including with reference to the drawings and specific examples and implementations. Briefly, with reference to the drawings, Figs. 1A-1J illustrate an example embodiment of a thermal management plate 100 described herein. As shown in Fig. 1A, 1B, and other example embodiments, the thermal management plate 100 comprises an exterior surface 101 defining an interior volume (not labeled). The exterior surface 101 can be a skin or shell or hollow casing surrounding or defining the interior volume or space. In some cases, at least 90% of the interior volume is occupied by the thermal management material. In other cases, at least 95%, at least 96%, at least 97%, at least 98%, or at least 99% of the interior volume is occupied by the thermal management material. In other embodiments, the thermal management material occupies 50-100%, 60-100%, 70-100%, 80-100%, 90-100%, 90-99%, 90-98%, 95-100%, or 95-98% of the interior volume of the plate 100. As described further herein, a thermal management plate having a structure described herein can be filled with a thermal management material to a greater extent and/or more easily than other containers.

The exterior surface 101 of the thermal management plate 100 includes a front side 102, a back side 103, and at least four corners 104. The corners 104 of the plate, in some instances, are rounded, whereas in other cases, the corners 104 are not rounded. For example, in some cases, any one or more of the four corners 104 can be a pointed corner, whereas in other cases, any one or more of the four corners can be a flattened or angled or "cut off" corner 105. A flattened or angled corner 105, in some embodiments, forms angles with each respective, adjacent edge 106 of the plate 100 that are equal in size. For example, in some cases, a flattened corner 105 makes a 45-degree angle with each edge 106 of the plate 100. Moreover, a flattened corner 105 provides a flat surface on a yz-plane of the plate, corresponding to a thickness or depth D3 of the plate.

The exterior surface 101, in some embodiments, is operable to facilitate heat transfer between an external environment and the interior volume, or between the external environment and a thermal management material disposed within the interior volume. For example, in some embodiments, the exterior surface can comprise or be formed from one or more materials that facilitate heat transfer, such as a thermal exchange material or a thermally conductive material. Any material operable to permit thermal exchange from the plate to the external environment can be used. Some non-limiting examples of materials suitable for use in forming a plate or panel described herein include a polymeric or plastic material (such as a polyethylene, polypropylene, polyethylene terephthalate, polyvinyl chloride, polycarbonate, polyoxymethylene, acrylonitrile butadiene styrene, or polyether ether ketone), a metal or mixture or alloy of metals (such as aluminum), and a composite material (such as a composite fiber or fiberglass). It is to be understood that the material forming or used to form the exterior surface of the plate, in some preferred embodiments, can generally form or define the entire body of the plate or substantially the entire body of the plate. Additionally, the material used to form the exterior surface (or the entire body or substantially the entire body of the plate) can be non-breathable or non-permeable to water, and/or non-flammable or fire-resistant. Moreover, in some instances, the material used to form the exterior surface (or the entire body or substantially the entire body of the plate) is non-electrically conductive, or has low or minimal electrical conductivity, such that the material is considered an electrical insulator rather than an electrical conductor. The use of a non-electrically conductive material to form the exterior surface 101 of a plate 100 described herein may be especially desirable, for example, if the plate is placed in a room or space in which sensitive and/or expensive electronic devices are used, such as a telecommunications shelter, data room, or data center in which computer systems, telecommunications hardware, and associated components are housed.

Further, in some cases, a thermally conductive material described above can be dispersed within a non-thermally conductive material or within a less thermally conductive material. In some embodiments, for example, a thermally conductive material comprises a paint, ink, or pigment, or a metal dispersed in a paint, ink, or pigment. Moreover, the paint, ink, or pigment can be used to form a design or decorative feature on the exterior surface of the plate.

Additionally, the material forming the exterior surface (or the entire body or substantially the entire body of the plate) can have any thickness not inconsistent with the objectives of the present disclosure. In some embodiments, the thickness is selected based on a desired mechanical strength and/or thermal conductivity. For example, in some cases, the average thickness of the material forming the exterior surface (or the entire body or substantially the entire body of the plate) is less than 20 mm, less than 10 mm, less than 5 mm, less than 3 mm, or less than 1 mm. In some embodiments, the average thickness is between 1 and 20 mm, between 1 and 15 mm, between 1 and 10 mm, between 1 and 5 mm, between 1 and 3 mm, between 3 mm and 10 mm, between 3 mm and 5 mm, or between 5 mm and 10 mm.

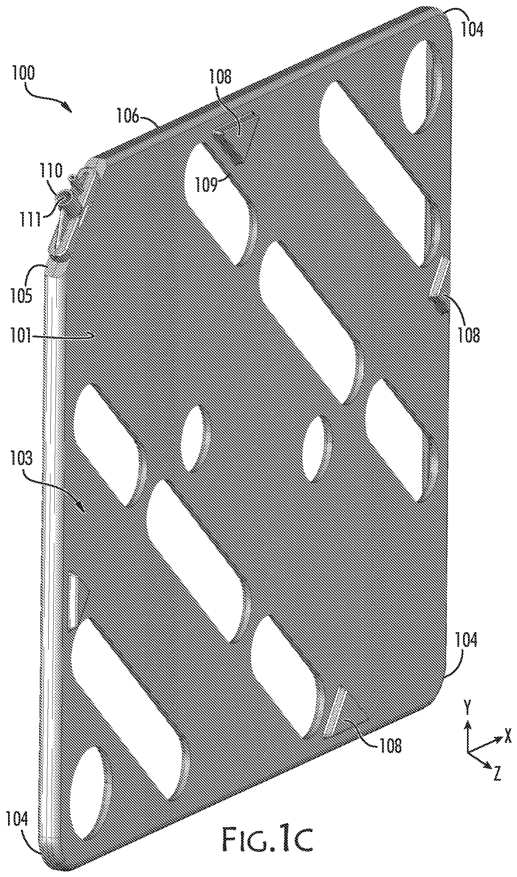

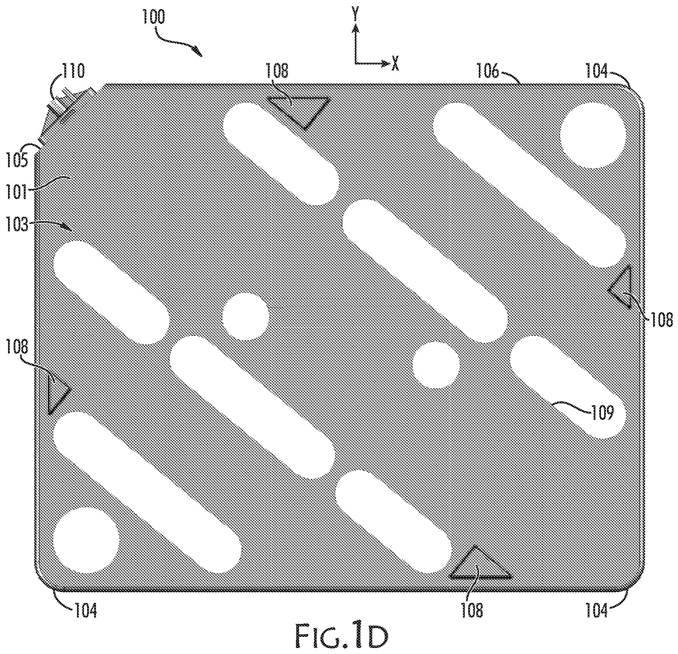

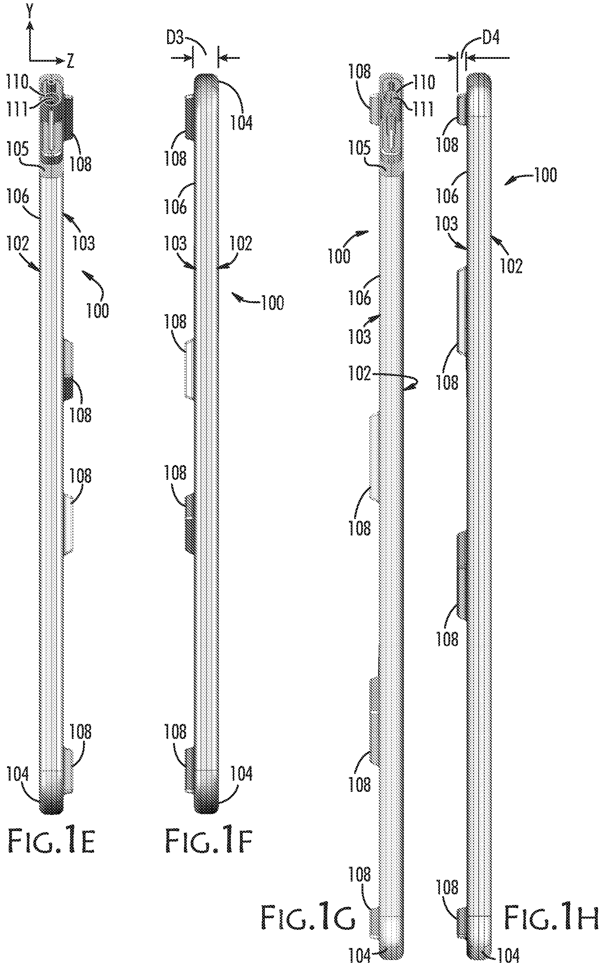

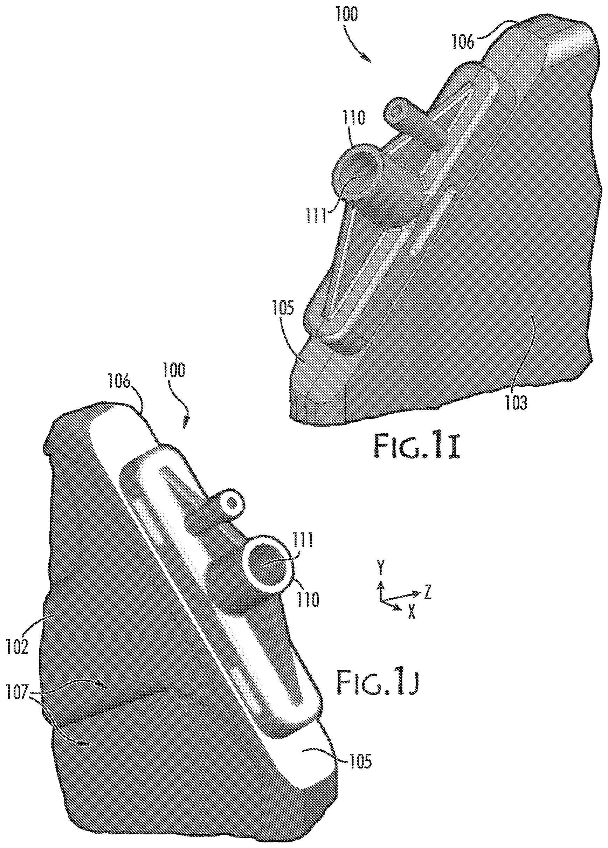

Moreover, in some embodiments, the exterior surface 101 of the plate 100 can have one or more features, such as edges 106 that are flat, rounded, bullnose, or beveled connecting the front 102 and back 103 sides of the exterior surface 101. Other features of a thermal management plate 100, as shown in Figure 1, can include one or more recessed regions 107, protrusions 108, and/or channels 109. In some cases, one or more features present on the front side 102 of the thermal management plate 100 are also present on the back side 103 of the thermal management plate 100. In other instances, the front side 102 can include one or more features absent from the back side 103 of the plate 100, or vice versa.

In certain preferred embodiments, the plate 100 (or the larger planar surfaces thereof) is generally rectangular in shape (though the corners may be rounded). In the example embodiment shown in Fig. 1B, a thermal management plate 100 has a width D1 and a length D2. D1 and D2 can have any value and ratio not inconsistent with the objectives of the present disclosure, and the sizes of D1 and D2 are not particularly limited. In some cases, the width D1 is less than 80 inches and the length D2 is less than 40 inches. In other embodiments, the width D1 is between 20 and 40 inches and the length D2 is between 12 and 24 inches. Further, in some cases, the front side 102 and back side 103 of the plate 100 can independently have a width D1 less than 80 inches and a length D2 less than 40 inches. In other cases, the front side 102 and back side 103 can independently have a width D1 between 20 and 40 inches and a length D2 between 12 and 24 inches. Moreover, it is further to be understood that the unique corner 105 can be in a location other than that shown in the embodiment of Fig. 1B. For instance, the unique corner 105 could be located where one of the three corners 104 is located in Fig. 1B, relative to D1 and D2.

In some embodiments, as shown in Fig. 1F, the plate 100 can have a depth D3 of less than 6 inches, less than 5 inches, less than 4 inches, less than 3 inches, less than 2 inches, less than 1 inch, or less than 0.5 inches. In other embodiments, the depth D3 can be between 0.3 inches and 6 inches, between 0.3 inches and 5 inches, between 0.3 inches and 4 inches, between 0.3 inches and 3 inches, between 0.5 inches and 3 inches, or between 0.5 inches and 1 inch. Other thicknesses are also possible.

In the example embodiment shown in Fig. 1A and Fig. 1B, as in certain other embodiments, but not all embodiments, the exterior surface 101 can comprise one or more recessed regions 107. For example, a recessed region 107 can be any area of the exterior surface 101 of the plate 100 that is recessed, depressed, sunken, or lowered compared to the edges 106 of the plate (without forming a through hole, perforation, or channel 109). The one or more recessed regions 107, in some cases, can increase the total surface area of the plate relative to the total interior volume of the plate. Thus, recessed regions, in other cases, can further increase the thermal transport performance of the plate 100. In some embodiments, a recessed region 107 can be within a larger recessed region. For example, in some cases such as in Fig. 1A and 1B, a recessed region 107 may appear as a faux channel having a flattened bottom. In other embodiments, a recessed region 107 is an entire region of the front side 102 or back side 103 that is recessed, depressed, sunken, or lowered compared to the edges 106, and a second recessed region 107, such as the faux channels of Fig. 1A and Fig 1B, are positioned within the larger recessed region 107 and are even further recessed, depressed, sunken, or lowered compared to the larger recessed region 107. However, as described further herein, it is to be understood that recessed regions 107, as shown in Figure 1, can be replaced with channels (such as the channels 109). Similarly, the channels 109 in Figure 1 could be partially or completely "filled in" to form other recessed regions 107 or non-recessed regions. In this manner, embodiments described herein can provide modularity and versatility in terms of the number and arrangement of channels or through holes.

In the example embodiment shown in Fig. 1C, the exterior surface 101 can further comprise protrusions 108 extending from the exterior surface 101. Protrusions 108 of the exterior surface 101, in some cases, can extend in an orthogonal or substantially orthogonal direction from the back side 103 of the plate 100, as shown in Figs. 1E to 1H. In other instances, protrusions 108 can extend from the front side of the plate. However, it is to be understood that, in some cases, the side from which the protrusions 108 extend is, for this reason, defined as the back side of the plate. As illustrated in Figs. 1E to 1H, a protrusion 108 can have a depth D4 that is separate and distinct from the plate depth D3. For example, the protrusion depth D4, in some embodiments, is less than 2 inches, less than 1 inch, or less than 0.5 inches. In some cases, the protrusion depth D4 is between 0.25 inches and 2 inches, between 0.25 inches and 1 inch, between 0.25 inches and 0.5 inches, or between 0.5 inches and 1 inch.

In some implementations, the protrusions 108 of the exterior surface 101 are solid extensions of the exterior surface. For example, a protrusion 108 can be formed from only the exterior surface 101, such that the thickness of the exterior surface 101 is greater at the protrusion 108 compared to a non-protruding region of the exterior surface 101. In other embodiments, a protrusion 108 of the exterior surface 101 can be mirrored by the interior volume such that the thickness of the exterior surface 101 remains the same across a transition from a non-protruding region to a protruding region (and such that the interior volume extends, so to speak, to a degree corresponding to the depth of the protrusion). Moreover, a protrusion described herein can be integrally formed with the exterior surface (or with the entire body or substantially the entire body of the plate, as may be provided by an injection molding process, for example). Alternatively, the protrusion can be formed from a separate material that is attached to the exterior surface of the plate.

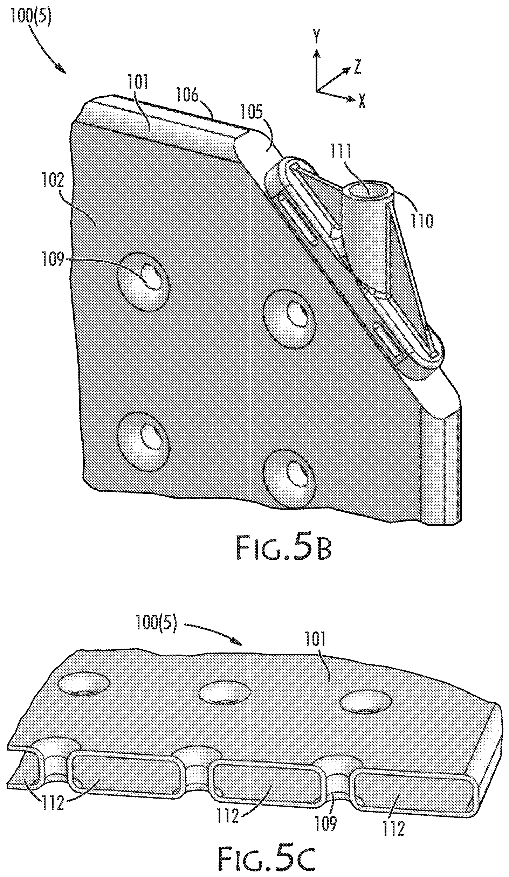

In the example embodiment of Figure 1, as in other preferred example embodiments, the exterior surface 101 can further comprise one or more channels, through-holes, or perforations 109. For example, Figs. 1A, 1B, 1C, and 1D illustrate channels 109 extending from the front side 102 to the back side 103, and connecting the front side 102 to the back side 103. As described above, one or more channels 109 present in a thermal plate 100 can increase the surface area of the thermal plate 100 or air flow "through" the thermal plate (from the front side to the back side). The presence, number, and size of channels can also be selected based on a desired thermal storage capacity of the plate (e.g., as determined by a volume or mass of thermal management material disposed within the interior volume of the plate, where a larger total channel volume corresponds to a smaller total volume of thermal management material, for a given size plate, due to the smaller total interior volume accessible for filling with thermal management material). The channels 109 can have any shape not inconsistent with the objectives of the present disclosure. For example, in some cases, a channel has a shape (e.g., a sectional shape when viewed from the front or the back side of the plate) that is generally circular, oval, or oblong. The shape can also be a polygonal shape having sharp or rounded corners. Further, in some embodiments, the channels 109 (or the "sidewalls" of the channels) can have straight, rounded, beveled, or bullnose edges connecting the front 102 and back 103 sides of the exterior surface 101. For example, Fig 1A illustrates an example embodiment of rounded edge channels 109. A beveled edge, for example, is illustrated in Fig. 5B and 5C. Additionally, the channels 109, in some embodiments, have an average thickness or depth (measured from the front side of the plate to the back side of the plate) corresponding to the thickness of the plate (distance D3), including as described above. Moreover, the channels can have any size in the orthogonal directions, corresponding to the major plane of the plate (the x and y directions in Figure 1), not inconsistent with the objectives of the present disclosure. For example, in some cases, the one or more channels have a size (such as an average size) in one or both of the planar directions (x and y) of up to 10 inches, up to 8 inches, up to 6 inches, up to 4 inches, or up to 2 inches. In other instances, the one or more channels have a size (e.g., average size) in one or both of the planar directions of less than 6 inches, less than 4 inches, less than 2 inches, or less than 1 inch. It is to be understood that the size of the channels is not particularly limited.

Additionally, in the example embodiment of Figure 1, as in other preferred example embodiments, a thermal management plate 100 described herein further comprises a fill spout 110 having an opening 111 in fluid communication with the interior volume of the plate 100 and an external environment of the plate 100. In some cases, the fill spout is generally cylindrical in shape. However, other shapes may also be used. The fill spout 110, in preferred embodiments, is disposed at one of the corners 104 or 105 of the exterior surface 101. In some embodiments, the fill spout 110 is positioned such that the volume of an air gap is reduced or minimized during the process of filling the internal volume of the plate 100. In other words, by being disposed at a corner 104 or 105, the air gap present during the process of filling is minimized and/or eliminated. For example, in some cases, the fill spout 110 is disposed at a flattened corner 105. A fill spout 110 disposed on a flattened corner 105 is positioned on a region of the exterior surface 101 of the plate 100 corresponding to the plate depth D3 and a yz-plane of the plate 100. Thus, an air gap present during the process of filling the internal volume of the plate 100 is eliminated or minimized to the surface area size of the exterior surface 101 at the flattened corner 105 or less. In some embodiments, the fill spout 110 further comprises an air outlet (e.g., the smaller cylinder near fill spout 110 in Fig. 1). The air outlet is operable to allow displaced air to exit the internal volume while filling the thermal management plate 100 via the fill spout 110. In other instances, the plate 100 does not include an air outlet for the release of displaced air as described above.

The fill spout opening 111, in some cases, is generally round. In other cases, the opening 111 can be oval or polygonal in shape. In the example embodiment of Figure 1, but not necessarily other embodiments, the plane of the opening 111 is generally parallel with the yz-plane of the flattened corner 105, or the exterior surface 101 at the flattened corner 105. In some embodiments, the surface area of the fill spout opening 111 is less than or equal to the surface area of the exterior surface 101 at the flattened corner 105.

In one example embodiment of Figs. 1I and 1J, but not necessarily others, the fill spout 110 is positioned such that an axial vector positioned through the fill spout opening 111 and down the center of the fill spout 110 intersects with an imaginary pointed corner of the plate 100. For example, in some cases, an axial vector positioned through the fill spout opening 111 and down the center of the fill spout 110 creates a 45-degree angle with each of an x-axis and y-axis of the plate 100 corresponding to the edges 106 and the width D1 and length D2 of the plate 100. However, the fill spout 110 and fill spout opening 111 can have other orientations relative to the xy-plane, xz-plane, or yz-plane, if desired. In certain preferred embodiments, the axial vector (or "long direction" or "fill direction") of the fill spout 110 and fill spout opening 111 lies within the xy-plane or substantially within the xy-plane (e.g., forming an angle of 10 degrees or less, or 5 degrees or less). It is further to be understood that a fill direction of a fill spout can correspond to the direction that is orthogonal to the plane of the fill spout opening, or to the direction a material (such as a thermal management material) flows into the fill spout and fill spout opening.

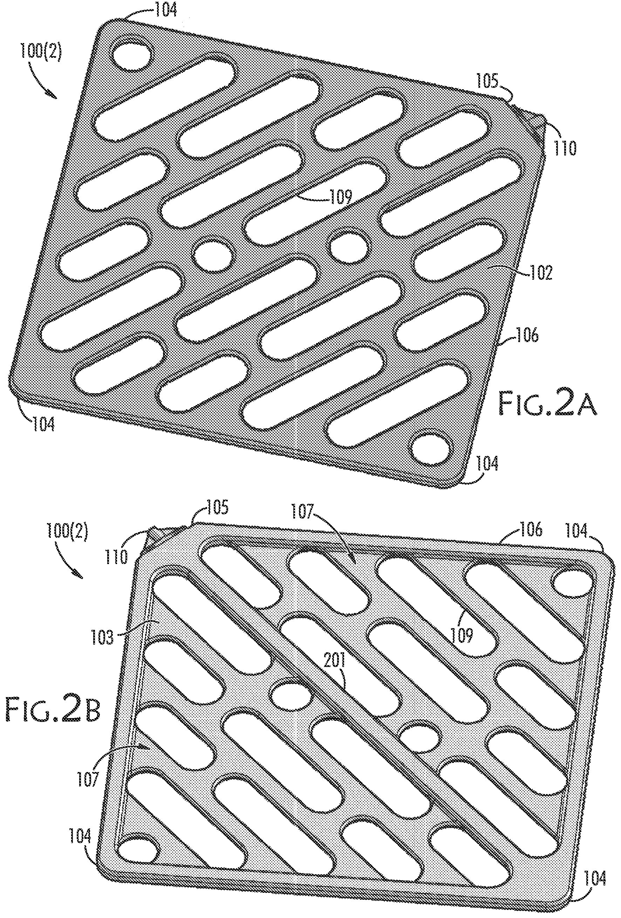

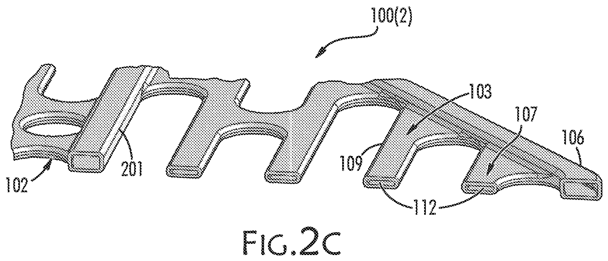

Figs. 2A, 2B, and 2C illustrate a second example embodiment of a thermal management plate 100(2). The second example embodiment differs from the first example embodiment in the recessed regions 107 and through the inclusion of a spine 201 (as further described below). Whereas in the first example embodiment, nearly the entire front side 102 is formed from a rectangular shaped recessed region 107 having, additionally, further recessed regions 107 appearing as faux channels, in the second example embodiment the back side 103 comprises two triangular recessed regions 107, leaving a spine 201 extending diagonally across the plate 100 from a flattened corner 105 to the opposite corner 104. The spine has a so-called "long" dimension (d1) extending diagonally from the flattened corner 105 to the opposite corner 104, as well as two so-called "short" dimensions (where the terms "long" and "short" are relative to one another). The short dimensions correspond to the thickness of the spine in the z-direction (which direction or dimension may be referred to as d2) and to the width of the spine in the xy-plane (which direction or dimension may be referred to as d3). Thus, the spine has a cross sectional area along its length defined by d2 x d3. As described further below, the spine 201 is hollow, since it forms or defines part of the overall interior or internal volume of the plate 100. Moreover, in the embodiment of Fig. 2, the interior volume of the spine is in fluid communication with the fill spout 110.

In further contrast to the first example embodiment and as illustrated in Fig. 2A and 2B, the second example embodiment lacks protrusions 108, faux channels, and a fill spout 110 comprising an air outlet. For example, in some embodiments, a thermal management plate does not have protrusions 108 and/or does not have an air outlet. The front 102 and back 103 sides of the plate 100(2) comprise various sized channels 109 that are uniformly positioned across the entire plate 100(2) and within a recessed region 107. Fig. 2C illustrates a perspective view of the interior volume of the plate 100(2).

As shown in Fig. 2C, the interior volume of a recessed region 107 is thinner than the interior volume of non-recessed regions. For example, the interior volume at the edges 106 and through the spine 201 is thicker (in the z-direction or d2 direction) than the interior volume of the recessed region 107. In some preferred embodiments, the thickness (d2) of the spine and/or the cross section of the spine (taken from the front of the plate to the back of the plate, corresponding to d2 x d3) is at least as large as the thickness or cross section of any other portion of the plate or panel. That is, the cross section of the spine or interior volume of the spine can be relatively large compared to other regions of the overall interior volume of the plate (such as within recessed regions or regions around through holes). The relatively large size or cross sectional area of the spine can thus provide increased access or ease of movement of material flowing into or through the spine, compared to access or movement of material flowing into or through other regions of the interior volume (such as regions around the through holes). In some cases, the average thickness of the spine (d2) and/or the average cross sectional area of the spine (d2 x d3) along the length of the spine (d1) is at least 1.5 times the average thickness or average cross sectional area of the plate overall. In some instances, the average thickness and/or the average cross sectional area of the spine is at least 2 times, at least 3 times, at least 5 times, or at least 10 times the average thickness or average cross sectional area of the plate overall. In some embodiments, the average thickness and/or the average cross sectional area of the spine is 1.5 to 15 times, 1.5 to 10 times, 1.5 to 5 times, 2 to 15 times, 2 to 10 times, 2 to 5 times, 3 to 15 times, 3 to 10 times, 3 to 5 times, 5-15 times, or 5-10 times the average thickness or average cross sectional area of the plate overall. Moreover, in some preferred embodiments, the spine has dimensions such as described above and the axial vector (or "long direction" or "fill direction" vector) of the fill spout and fill spout opening lies within the xy-plane or substantially within the xy-plane and is aligned or parallel with, or substantially aligned or parallel (e.g., within 10 degrees or within 5 degrees of parallel) with, a vector defining the long dimension of the spine (d1). Thus, in some embodiments, the fill direction or long direction or axial direction of the fill spout is the same direction as the direction of the long axis of the spine. Not intending to be bound by theory, it is believed that a plate or panel having such a structure can be filled with a thermal management material more efficiently than in some other instances.

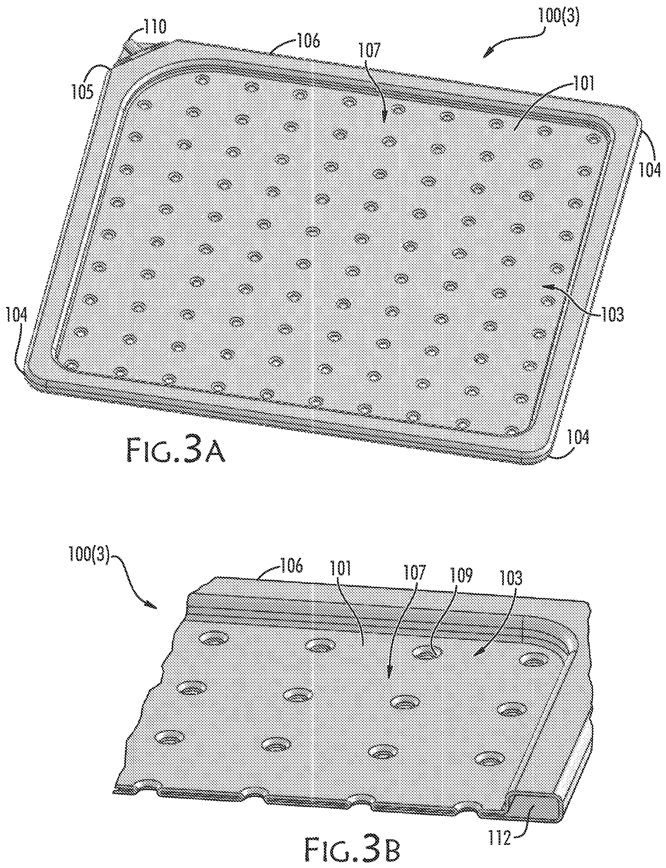

Figs. 3A and 3B illustrate a third example embodiment of a thermal management plate 100(3) which differs from either the first example embodiment or the second example embodiment, including by having channels 109 of a single shape and size that are circular and smaller. In addition and similar to Fig. 2C, Fig. 3B illustrates the internal volume of a thermal management plate 100(3) wherein the interior volume of the recessed region 107 is thinner than the interior volume of the non-recessed regions. For example, the interior volume at the edges 106 is thicker than the interior volume of the recessed region 107. In contrast to Fig. 2C, Fig. 3B illustrates a larger amount of interior volume due to the smaller sized channels 109.

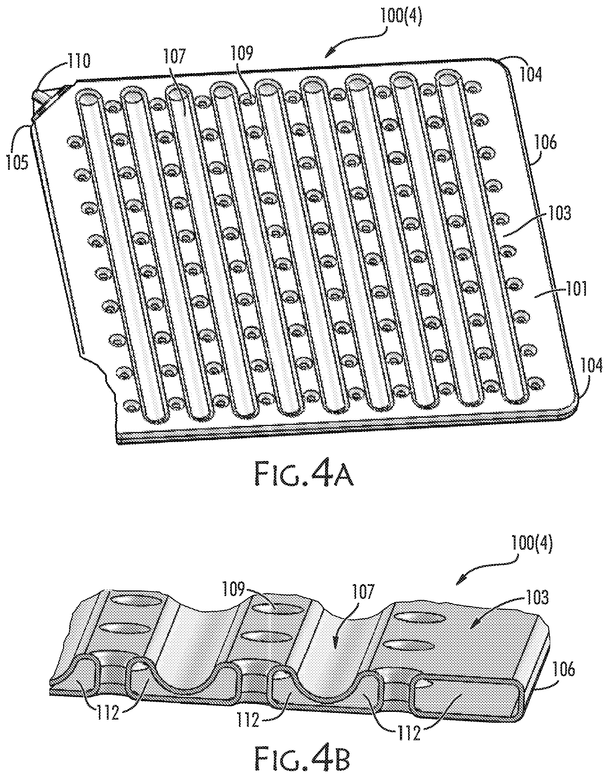

Figs. 4A and 4B illustrate a fourth example embodiment of a thermal management plate 100(4) which differs from either the first, second, or third example embodiment, including by having recessed regions 107 that appear as grooves on the back side 103 and channels 109 that are positioned within a non-recessed region. As shown in Fig. 4B, the recessed regions 107, or grooves, are positioned as rows between the channels 107 and provide a greater surface area to volume ratio to the plate 100(4).

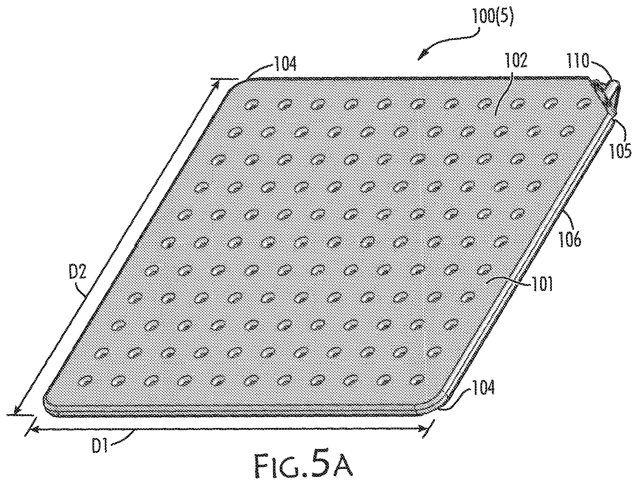

Figs. 5A, 5B, and 5C illustrate a fifth example embodiment of a thermal management plate 100(5) which differs from either the first, second, third, or fourth example embodiment, including by having a fill spout 110 positioned in parallel with an edge 106 corresponding to the length D2 and a fill spout opening 111 positioned in parallel with the opposite edge 106 corresponding to the width D1. Fig. 5B provides an enlarged, perspective view of an example embodiment of a fill spout 110 positioned such that an axial vector extending through the fill spout opening 111 and down the center of the fill spout 110 is substantially parallel to a y-axis of the plate 100(5) corresponding to the directions of the length D2 of the plate 100(5). In addition, unlike previous example embodiments, the fifth example embodiment of a thermal management plate 100(5) lacks any recessed regions 107. For example, in some embodiments, a thermal management plate does not have a recessed region 107. Thus, as illustrated in Fig. 5C, the internal volume across the plate 100(5) is substantially uniform throughout the plate 100(5) and the thickness or depth of the plate D3 is relatively uniform across the external surface 101, except where the channels 109 are located.

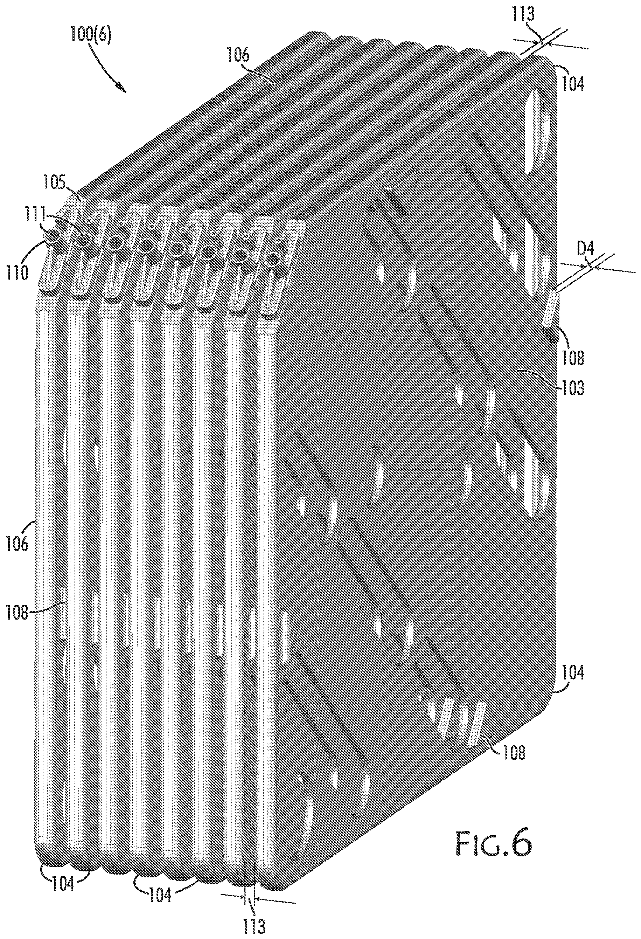

Fig. 6 illustrates a sixth example embodiment of a stack of thermal management plates 100(6) wherein a plurality of thermal management plates are adjacently positioned or stacked in a front-to-back orientation. For illustrative purposes only, the thermal management plates 100 of the first example embodiment are shown, which have protrusions 108 extending from the back side 103. It should be understood that the protrusions 108 extending from the back side 103 of a first plate are in contact with the front side 102 of an adjacent second plate 100 and the protrusions 108 of the first plate do not align with channels 109 of the adjacent second plate 100. Moreover, the protrusions 108 are operable to form one or more gaps 113 between each plate 100(6) and/or an adjacent surface, such as a wall. In some embodiments, a gap 113 between adjacent plates in a front-to-back orientation can be formed from one or more recessed regions 107. For example, when a front side 102 or a back side 103 of a first plate having one or more recessed regions 107 is positioned against a surface, such as a wall or a second plate in a front-to-back orientation, the one or more recessed regions 107 of the first plate prevent the front side 102 or back side 103 of the first plate from being wholly flush against the wall or the second plate, and thus can create a gap 113.

The gap 113 of a thermal plate described herein, in some embodiments, is operable to ventilate the front side 102 or back side 103 of the first plate. In some instances, wherein a first plate 100 is in contact with a second plate, the front side 102 or back side 103 of the second plate can also be ventilated via the gap 113. For example, a gap 113 formed from recessed regions 107 and/or protrusions 108 on the exterior surface 101 of a first plate 100 and an adjacent surface can ventilate through one or more channels 109 present in the recessed region 107. In another example, a gap 113 formed from one or more protrusions 108 on the exterior surface 101 of a first plate 100 and an adjacent surface can ventilate through a side of the gap 113 and/or one or more channels 109 present on the exterior surface 101. In some cases, the gap 113 has an average depth that is less than or equal to the protrusion depth D4. For example, the gap can have an average depth of less than 6 inches, less than 5 inches, less than 4 inches, less than 3 inches, less than 2 inches, or less than 1 inch. In other embodiments, the gap can be between 0.25 inches and 6 inches, between 0.5 inches and 6 inches, between 1 inch and 6 inches, between 1 inch and 5 inches, between 0.5 inches and 4 inches, between 0.5 and 3 inches, between 0.25 and 5 inches, between 0.25 and 4 inches, between 0.25 and 3 inches, or between 0.25 and 2 inches.

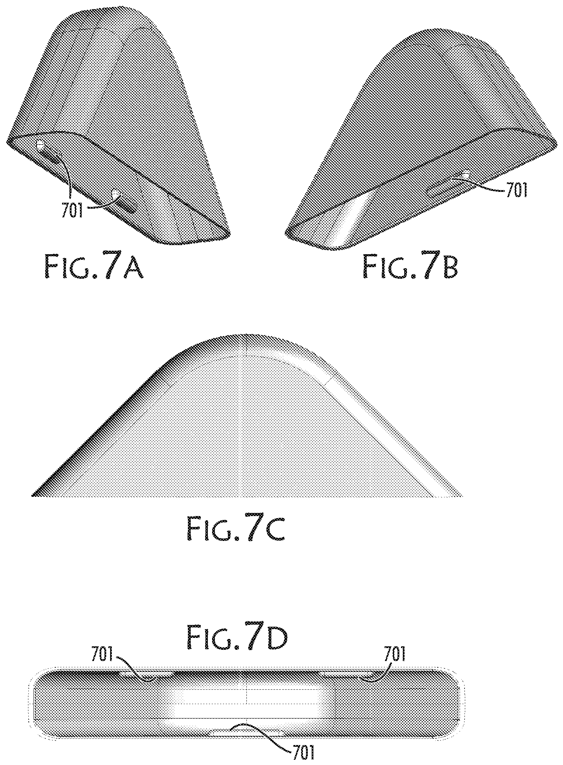

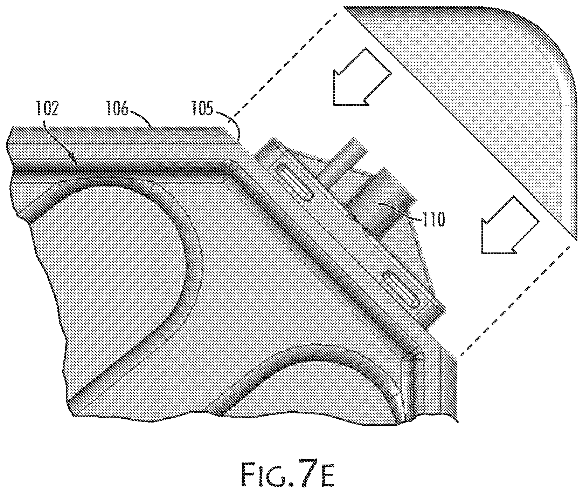

In some embodiments, a plate or panel described herein further comprises a cap. As shown in Figs. 7A-7E the cap, in some embodiments, can be a snap-on cap having securable ridges 701 that allow the cap to snap into a secured positioned over the fill spout 110. In some preferred embodiments, a cap positioned over the fill spout 110 covers and/or conceals the fill spout 110. In some cases, the cap covers and/or conceals both the fill spout 110 and an air outlet. For example, the surfaces of the cap, when securely positioned over the fill spout 110, can align with the exterior surface 101 of the plate 100 to conceal the corner fill spout 110, generating a complete rounded or pointed corner 104 similar to the other corners of the plate 100, and consequently concealing a flattened corner 105. In other embodiments, the cap can be a twist-on or screw-on cap having threads that align with threads present on the fill spout 110. In some embodiments, the cap may further comprise a seal, closure, or gasket to securely seal or close off the fill spout opening 111 from an external environment and prevent contents or materials disposed within the plate 100 from leaking or otherwise exiting. In still other cases, the fill spout opening 111 can be closed in another manner. Moreover, in some embodiments, an adhesive can be disposed between a cap and other portions of the plate. That is, a cap described herein can be adhered over the fill spout using an adhesive, alone or in combination with a snap-on closure, screw-on closure, seal, or gasket.

With reference to the figures, it is be understood that a plate or panel described herein can include other combinations or permutations of features, in addition to those combinations illustrated in the example embodiments depicted in the figures. For example, a plate or panel described herein can comprise a spine as described herein in combination with any fill spout, fill spout opening, or unique or angled corner described herein, as well as in combination with any cap described herein. A plate or panel described herein, in some implementations, can also include any number, size, or shape of channels or through holes in combination with any spine, fill spout, fill spout opening, unique or angled corner, or cap described herein.

A plate described herein can also comprise or include one or more additional components that may either facilitate a thermal management function or may provide auxiliary function. For example, in some embodiments, the plate comprises at least one fan that directs air flow from an external environment to the thermal management material and/or from a thermal management material to the external environment. In some preferred embodiments, the fan is positioned within a channel, through hole, or perforation 109. The fan, in concert with one or more recessed regions 107, one or more channels 109, and/or one or more gaps 113, can facilitate heat transfer between a thermal management material disposed within the interior volume of one or more plates 100 and an external environment.

In some cases, a plate comprises a plurality of fans. In some such instances, a plate 100 can comprise a first fan (or plurality of fans) that rotates in a clockwise direction and a second fan (or plurality of fans) that rotates in a counterclockwise direction. Moreover, the first and second fans (or pluralities of fans) can be positioned in or on the plate 100 to direct air flow cooperatively from the external environment to the thermal management material and from the thermal management material back to the external environment. Furthermore, the plate 100 may comprise or include a power source by which to power the fan(s). For example, the plate 100 can comprise or include a photovoltaic cell that powers the fan(s). Such a photovoltaic cell may be placed on the exterior surface 101 of the plate 100, and may be a rigid or flexible photovoltaic cell. In other embodiments, the fan(s) are thermoelectrically powered. Moreover, in some cases, a thermoelectric fan of a plate 100 described herein uses thermal energy provided by or emanating from the plate or by a heat source within the external environment or by "excess" ambient heat in the external environment. In this manner, such a thermoelectric fan can further assist with efficient thermal management by the plate 100, particularly for cooling applications. Any combination or sub-combination of one or more fans and one or more power sources such as a photovoltaic cell can be used.

In some embodiments, a plate described herein can further comprise a mounting mechanism or a mounting bracket, such as a mounting track or mounting pegs or mounting rails. The mounting bracket can reversibly attach and/or interface with one or more features of the plate 100. For example, in some cases, a mounting bracket can have one or more grooves to securely fasten one or more protrusions 108 of a plate 100 to the mounting bracket. The protrusions can, in some cases, slide, twist, or snap into the one or more grooves. In another example, a mounting bracket can have pegs or arm extensions that penetrate one or more channels 109 of a plate 100, thereby securing and/or suspending one or more plates 100 from the pegs. In still other implementations, a mounting mechanism comprises two or more parallel rails. Such rails can be spaced apart by a distance corresponding approximately to a length or width of a plate (e.g., corresponding to distance D1 or D2). Moreover, the rails can include one or more structures (such as one or more grooves, ridges, and/or lips) that can retain a plate that is "snapped" into the structures, such as between two parallel rails. That is, a plate can be "snapped into" a top rail and a bottom rail that is substantially parallel to the top rail. The set of two rails can thus be used to hold the plate in place. Such rails, in some embodiments, are attached to a wall (e.g., with nails, screws, or other mechanical fasteners) of a room, such as a data center or other room whose temperature is to be managed by the plate. Moreover, a set of rails, in some implementations, is configured to retain a plurality of plates in a side-by-side configuration (as opposed to stacked configuration or a "front-to-back" configuration), where each plate is substantially flush against the wall to which the rails are attached. In some instances, a protrusion of the plate creates a space between the plate and the wall, even when the plate is disposed in the rails. Moreover, in still other implementations, more than two parallel rails may be used to mount a plurality of plates. For instance, in some cases, at least three parallel rails are used, and the middle rail acts as the top rail (of a first "set" of parallel rails) for a first "row" of plates and also simultaneously as the bottom rail (of a second "set" of parallel rails) for a second "row" of plates above the first row.

As described herein, a plate can comprise a thermal management material disposed within the interior volume of the plate. In some preferred embodiments, the thermal management material comprises or is a phase change material (PCM). As understood by one of ordinary skill in the art, a PCM can store or release thermal energy in the process of undergoing a phase transition (such as between a solid state and a liquid state, or between a solid state and a gel state). For example, a PCM can absorb thermal energy from the external environment (e.g., produced by equipment or other heat sources in a room, such as a data center) and use the thermal energy to undergo a phase transition (e.g., a melting event), without increasing in temperature. The absorbed thermal energy is instead "stored" as latent heat within the PCM. In this manner, the temperature of the external environment can be decreased (as compared to what the temperature would be in the absence of the PCM). At a later time (e.g., at night or when the heat sources within the environment are producing less excess thermal energy), the PCM can release the stored thermal energy (in the form of latent heat) by undergoing the opposite phase transition as before (e.g., a freezing event). In this manner, the PCM can be "recharged" for another cycle of thermal energy absorption (e.g., during the day or when the heat sources within the environment are producing a relatively large amount of excess heat).

Any PCM not inconsistent with the objectives of the present disclosure may be used in a device or method described herein. Moreover, the PCM (or combination of PCMs) used in a particular instance can be selected based on a relevant operational temperature range for the specific end use or application. For example, in some cases, the PCM has a phase transition temperature within a range suitable for cooling or helping to maintain a desired temperature or set point in a residential or commercial building or portion thereof. In some such instances, the building or portion thereof is a telecom shelter, data center or data room, or an attic. In other embodiments, the building or portion thereof is a refrigerated room, warehouse, or other space, or is a freezer. In other instances, the PCM has a phase transition temperature suitable for the thermal energy management of so-called waste heat. In some embodiments, the PCM has a phase transition temperature within one of the ranges of Table 1 below.

**Table 1. Phase transition temperature ranges for PCMs (at a pressure of 1 atm).**

| **Phase Transition Temperature Ranges** |
|---|
| 450-550°C |
| 300-550°C |
| 70-100°C |
| 60-80°C |
| 40-50°C |
| 25-40°C |
| 25-30°C |
| 20-30°C |
| 20-25°C |
| 18-25°C |
| 16-23°C |
| 16-18°C |
| 15-20°C |
| 6-8°C |
| 2-10°C |
| 2-8°C |
| -40 to -10°C |

Moreover, in certain embodiments, it may be desirable or even preferable that a phase transition temperature of the PCM or mixture of PCMs is at or near a desired set-point temperature in an interior of a room or an external environment. Any desired room temperature or external temperature and associated phase transition temperature can be used. For example, in some embodiments, a phase transition temperature is between about 15°C and about 32°C at 1 atm, such as between about 17°C and about 30°C at 1 atm, between about 19°C and about 28°C, or between about 21°C and about 26°C at 1 atm. Further, in some cases, a phase transition temperature is between about 17°C and about 32°C at 1 atm, such as between about 19°C and about 32°C at 1 atm, between about 21°C and about 32°C at 1 atm, between about 23°C and about 32°C at 1 atm, or between about 25°C and about 32°C at 1 atm. Moreover, in some embodiments, a phase transition temperature is between about 15°C and about 30°C at 1 atm, such as between about 15°C and about 28°C at 1 atm, between about 15°C and about 26°C at 1 atm, or between about 15°C and about 24°C at 1 atm.

As described further herein, a particular range can be selected based on the desired application. For example, PCMs having a phase transition temperature of 20-25°C can be especially desirable to assist in the cooling of data centers, while PCMs having a phase transition temperature of 6-8°C can be especially desirable for maintaining the temperature of a refrigerated space. As another non-limiting example, PCMs having a phase transition between - 40°C and -10°C can be preferred for use in commercial freezer cooling.

Further, a PCM of a device or method described herein can either absorb or release energy using any phase transition not inconsistent with the objectives of the present disclosure. For example, the phase transition of a PCM described herein, in some embodiments, comprises a transition between a solid phase and a liquid phase of the PCM, or between a solid phase and a mesophase of the PCM. A mesophase, in some cases, is a gel phase. Thus, in some instances, a PCM undergoes a solid-to-gel transition.

Moreover, in some cases, a PCM or mixture of PCMs has a phase transition enthalpy of at least about 50 kJ/kg or at least about 100 kJ/kg. In other embodiments, a PCM or mixture of PCMs has a phase transition enthalpy of at least about 150 kJ/kg, at least about 200 kJ/kg, at least about 300 kJ/kg, or at least about 350 kJ/kg. In some instances, a PCM or mixture of PCMs has a phase transition enthalpy between about 50 kJ/kg and about 350 kJ/kg, between about 100 kJ/kg and about 350 kJ/kg, between about 100 kJ/kg and about 220 kJ/kg, or between about 100 kJ/kg and about 250 kJ/kg.

In addition, a PCM of a device or method described herein can have any composition not inconsistent with the objectives of the present disclosure. In some embodiments, for instance, a PCM comprises an inorganic composition. In other cases, a PCM comprises an organic composition. In some instances, a PCM comprises a salt hydrate. Suitable salt hydrates include, without limitation, CaCl₂ • 6H₂O, Ca(NO₃)₂ • 3H₂O, NaSO₄ • 10H₂O, Na(NO₃)₂ • 6H₂O, Zn(NO₃)₂ • 2H₂O, FeCl₃ • 2H₂O, Co(NO₃)₂ • 6H₂O, Ni(NO₃)₂ • 6H₂O, MnCl₂ • 4H₂O, CH₃COONa • 3H₂O, LiC₂H₃O₂ • 2H₂O, MgCl₂ • 4H₂O, NaOH • H₂O, Cd(NO₃)₂ • 4H₂O, Cd(NO₃)₂ • 1H₂O, Fe(NO₃)₂ • 6H₂O, NaAl(SO₄)₂ • 12H₂O, FeSO₄ • 7H₂O, Na₃PO₄ • 12H₂O, Na₂B₄O₇ • 10H₂O, Na₃PO₄ • 12H₂O, LiCH₃COO • 2H₂O, and/or mixtures thereof.

In other embodiments, a PCM comprises a fatty acid. A fatty acid, in some embodiments, can have a C4 to C28 aliphatic hydrocarbon tail. Further, in some embodiments, the hydrocarbon tail is saturated. Alternatively, in other embodiments, the hydrocarbon tail is unsaturated. In some embodiments, the hydrocarbon tail can be branched or linear. Non-limiting examples of fatty acids suitable for use in some embodiments described herein include caprylic acid, capric acid, lauric acid, myristic acid, palmitic acid, stearic acid, arachidic acid, behenic acid, lignoceric acid, and cerotic acid. In some embodiments, a PCM described herein comprises a combination, mixture, or plurality of differing fatty acids. For reference purposes herein, it is to be understood that a chemical species described as a "Cn" species (e.g., a "C4" species or a "C28" species) is a species of the identified type that includes exactly "n" carbon atoms. Thus, a C4 to C28 aliphatic hydrocarbon tail refers to a hydrocarbon tail that includes between 4 and 28 carbon atoms.

In some embodiments, a PCM comprises an alkyl ester of a fatty acid. Any alkyl ester not inconsistent with the objectives of the present disclosure may be used. For instance, in some embodiments, an alkyl ester comprises a methyl ester, ethyl ester, isopropyl ester, butyl ester, or hexyl ester of a fatty acid described herein. In other embodiments, an alkyl ester comprises a C2 to C6 ester alkyl backbone or a C6 to C12 ester alkyl backbone. In some embodiments, an alkyl ester comprises a C12 to C28 ester alkyl backbone. Further, in some embodiments, a PCM comprises a combination, mixture, or plurality of differing alkyl esters of fatty acids. Non-limiting examples of alkyl esters of fatty acids suitable for use in some embodiments described herein include methyl laurate, methyl myristate, methyl palmitate, methyl stearate, methyl palmitoleate, methyl oleate, methyl linoleate, methyl docosahexanoate, methyl ecosapentanoate, ethyl laurate, ethyl myristate, ethyl palmitate, ethyl stearate, ethyl palmitoleate, ethyl oleate, ethyl linoleate, ethyl docosahexanoate, ethyl ecosapentanoate, isopropyl laurate, isopropyl myristate, isopropyl palmitate, isopropyl stearate, isopropyl palmitoleate, isopropyl oleate, isopropyl linoleate, isopropyl docosahexanoate, isopropyl ecosapentanoate, butyl laurate, butyl myristate, butyl palmitate, butyl stearate, butyl palmitoleate, butyl oleate, butyl linoleate, butyl docosahexanoate, butyl ecosapentanoate, hexyl laurate, hexyl myristate, hexyl palmitate, hexyl stearate, hexyl palmitoleate, hexyl oleate, hexyl linoleate, hexyl docosahexanoate, and hexyl ecosapentanoate.

In some embodiments, a PCM comprises a fatty alcohol. Any fatty alcohol not inconsistent with the objectives of the present disclosure may be used. For instance, a fatty alcohol, in some embodiments, can have a C4 to C28 aliphatic hydrocarbon tail. Further, in some embodiments, the hydrocarbon tail is saturated. Alternatively, in other embodiments, the hydrocarbon tail is unsaturated. The hydrocarbon tail can also be branched or linear. Non-limiting examples of fatty alcohols suitable for use in some embodiments described herein include capryl alcohol, pelargonic alcohol, capric alcohol, undecyl alcohol, lauryl alcohol, tridecyl alcohol, myristyl alcohol, pentadecyl alcohol, cetyl alcohol, heptadecyl alcohol, stearyl alcohol, nonadecyl alcohol, arachidyl alcohol, heneicosyl alcohol, behenyl alcohol, lignoceryl alcohol, ceryl alcohol, and montanyl alcohol. In some embodiments, a PCM comprises a combination, mixture, or plurality of differing fatty alcohols.

In some embodiments, a PCM comprises a fatty carbonate ester, sulfonate, or phosphonate. Any fatty carbonate ester, sulfonate, or phosphonate not inconsistent with the objectives of the present disclosure may be used. In some embodiments, a PCM comprises a C4 to C28 alkyl carbonate ester, sulfonate, or phosphonate. In some embodiments, a PCM comprises a C4 to C28 alkenyl carbonate ester, sulfonate, or phosphonate. In some embodiments, a PCM comprises a combination, mixture, or plurality of differing fatty carbonate esters, sulfonates, or phosphonates. In addition, a fatty carbonate ester described herein can have two alkyl or alkenyl groups described herein or only one alkyl or alkenyl group described herein.

Moreover, in some embodiments, a PCM comprises a paraffin. Any paraffin not inconsistent with the objectives of the present disclosure may be used. In some embodiments, a PCM comprises n-dodecane, n-tridecane, n-tetradecane, n-pentadecane, n-hexadecane, n-heptadecane, n-octadecane, n-nonadecane, n-eicosane, n-heneicosane, n-docosane, n-tricosane, n-tetracosane, n-pentacosane, n-hexacosane, n-heptacosane, n-octacosane, n-nonacosane, n-triacontane, n-hentriacontane, n-dotriacontane, n-tritriacontane, and/or mixtures thereof.

In addition, in some embodiments, a PCM comprises a polymeric material. Any polymeric material not inconsistent with the objectives of the present disclosure may be used. Non-limiting examples of suitable polymeric materials for use in some embodiments described herein include thermoplastic polymers (e.g., poly(vinyl ethyl ether), poly(vinyl n-butyl ether) and polychloroprene), polyethylene glycols (e.g., CARBOWAX^{®} polyethylene glycol 400, CARBOWAX^{®} polyethylene glycol 600, CARBOWAX^{®} polyethylene glycol 1000, CARBOWAX^{®} polyethylene glycol 1500, CARBOWAX^{®} polyethylene glycol 4600, CARBOWAX^{®} polyethylene glycol 8000, and CARBOWAX^{®} polyethylene glycol 14,000), and polyolefins (e.g., lightly crosslinked polyethylene and/or high density polyethylene).

Additional non-limiting examples of phase change materials suitable for use in some embodiments described herein include BioPCM materials commercially available from Phase Change Energy Solutions (Asheboro, North Carolina), such as BioPCM-(-8), BioPCM-(-6), BioPCM-(-4), BioPCM-(-2), BioPCM-4, BioPCM-6, BioPCM 08, BioPCM-Q12, BioPCM-Q15, BioPCM-Q18, BioPCM-Q20, BioPCM-Q21, BioPCM-Q23, BioPCM-Q25, BioPCM-Q27, BioPCM-Q30, BioPCM-Q32, BioPCM-Q35, BioPCM-Q37, BioPCM-Q42, BioPCM-Q49, BioPCM-55, BioPCM-60, BioPCM-62, BioPCM-65, BioPCM-69, and others.

It is further to be understood that a device described herein can comprise a plurality of differing PCMs, including differing PCMs of differing types. Any mixture or combination of differing PCMs not inconsistent with the objectives of the present disclosure may be used. In some embodiments, for example, a thermal management plate or panel comprises one or more fatty acids and one or more fatty alcohols. Further, as described above, a plurality of differing PCMs, in some cases, is selected based on a desired phase transition temperature and/or latent heat of the mixture of PCMs.

Moreover, in some cases, the PCM or combination or mixture of PCMs does not comprise ice, or does not consist essentially of ice, or does not consist of ice. That is, in some preferred embodiments, ice is not used as the PCM or thermal management material of a device described herein. It is to be understood that "ice" is water ice.

Further, in some embodiments, one or more properties of a PCM described herein can be modified by the inclusion of one or more additives. Such an additive described herein can be mixed with a PCM and/or disposed in a device described herein. In some embodiments, an additive comprises a thermal conductivity modulator. A thermal conductivity modulator, in some embodiments, increases the thermal conductivity of the PCM. In some embodiments, a thermal conductivity modulator comprises carbon, including graphitic carbon. In some embodiments, a thermal conductivity modulator comprises carbon black and/or carbon nanoparticles. Carbon nanoparticles, in some embodiments, comprise carbon nanotubes and/or fullerenes. In some embodiments, a thermal conductivity modulator comprises a graphitic matrix structure. In other embodiments, a thermal conductivity modulator comprises an ionic liquid. In some embodiments, a thermal conductivity modulator comprises a metal, including a pure metal or a combination, mixture, or alloy of metals. Any metal not inconsistent with the objectives of the present disclosure may be used. In some embodiments, a metal comprises a transition metal, such as silver or copper. In some embodiments, a metal comprises an element from Group 13 or Group 14 of the periodic table. In some embodiments, a metal comprises aluminum. In some embodiments, a thermal conductivity modulator comprises a metallic filler dispersed within a matrix formed by the PCM. In some embodiments, a thermal conductivity modulator comprises a metal matrix structure or cage-like structure, a metal tube, a metal plate, and/or metal shavings. Further, in some embodiments, a thermal conductivity modulator comprises a metal oxide. Any metal oxide not inconsistent with the objectives of the present disclosure may be used. In some embodiments, a metal oxide comprises a transition metal oxide. In some embodiments, a metal oxide comprises alumina.

In other embodiments, an additive comprises a nucleating agent. A nucleating agent, in some embodiments, can help avoid subcooling, particularly for PCMs comprising finely distributed phases, such as fatty alcohols, paraffinic alcohols, amines, and paraffins. Any nucleating agent not inconsistent with the objectives of the present disclosure may be used.

In still other instances, an additive comprises a fire retardant or fire resistant material.

A thermal management plate or panel described herein can be made in any manner not inconsistent with the objectives of the present disclosure. In some cases, for instance, a plastic or metal plate or panel is made by a molding or casting, such as by injection molding. Other methods of making a panel or plate described herein may also be used, as readily understood by those of ordinary skill in the art. Similarly, the manner of filling a plate or panel described herein with a thermal management material such as a PCM is not particularly limited. In some cases, a gravimetric method is used. In other cases, pressurized PCM is injected into the fill spout of a plate or panel described herein.

### II. Methods of Managing Temperature

In another aspect, methods of managing temperature are described herein. Any one or more of the devices, as described above in Section I, can be used in any one or more methods of managing temperature, as described herein. For example, a device can be a thermal management plate having any one or more of the features described in Section I above.

In some embodiments, methods of managing the temperature of a room or space (such as a data center, data storage room, freezer, refrigerated warehouse, or other space) are described herein. Such a room or space can include any room or space not inconsistent with the objectives of the present disclosure. A telecom shelter, data center or data storage room, for example, has at least three walls, a floor, and a ceiling, and comprises electronic devices, such as electronic servers and/or electronic storage hardware, disposed within the room. A method of managing the temperature of a room or space, in some embodiments, comprises disposing one or more thermal management plates or panels, as described above, in the interior of the room. Additionally, in some instances, disposing the plates or panels in the room comprises positioning the plates or panels so the back sides of one or more plates face a wall of the room or a ceiling of the room. Further, in some instances, one or more plates are suspended from, hung from, mounted on, or attached to the wall or ceiling, including, if desired, in a manner described above in Section I.

For example, in some embodiments, the one or more plates are suspended from a mounting mechanism or a mounting bracket on the wall, such as a mounting track or mounting pegs. For instance, a mounting bracket having a track with grooves configured to receive one or more features or structures of the one or more plates, such as edges or protrusions, can be positioned on a wall and one or more plates suspended from the mounting bracket via the mounting track. Engaging one or more features or structures of the one or more plates with the track securely fastens the one or more plates to the mounting bracket and suspends, hangs, or attaches the one or more plates 100 from the wall. In another example, a mounting bracket having one or more pegs configured to penetrate one or more channels described herein can be positioned on a wall and the one or more plates suspended from the mounting bracket via the one or more pegs. Engaging one or more features, such as channels, of the one or more plates with the pegs securely suspends the one or more plates from the mounting bracket and suspends the one or more plates from the wall.

In some cases, a plurality of plates are disposed in the room and the plurality of plates are positioned in a front-to-back orientation. For example, in some cases a plurality of plates can be adjacently positioned in a front-to-back orientation on the same one or more pegs to generate a stack of plates. In some cases, multiple stacks of plates positioned in a front-to-back orientation are disposed in the room. It is also possible for a plurality of plates to be arranged in a side-to-side configuration, as described above in Section I.

In some embodiments, a method further comprises providing at least one fan that directs air flow from the room to the thermal management material and/or from a thermal management material to the external environment. In some preferred embodiments, the fan is positioned within a channel, through hole, or perforation. The fan, in concert with one or more recessed regions, one or more channels, and/or one or more gaps, can facilitate heat transfer between a thermal management material disposed within the interior volume of the plate and an external environment (e.g., the room in which the plate is placed).

In some cases, a method described herein comprises providing a plurality of fans. In some such instances, a plate can comprise a first fan (or plurality of fans) that rotates in a clockwise direction and a second fan (or plurality of fans) that rotates in a counterclockwise direction. Moreover, the first and second fans (or pluralities of fans) can be positioned in or on the plate to direct air flow cooperatively from the external environment to the thermal management material and from the thermal management material back to the external environment. Furthermore, the plate may comprise or include a means by which to power the fan(s). For example, the plate can comprise or include a photovoltaic cell that powers the fan(s). Such a photovoltaic cell may be placed on the exterior surface of the plate, and may be a rigid or flexible photovoltaic cell. In other embodiments, the fan(s) are thermoelectrically powered. Moreover, in some cases, a thermoelectric fan of a plate described herein uses thermal energy provided by or emanating from the plate or by a heat source within the external environment or by "excess" ambient heat in the external environment. In this manner, such a thermoelectric fan can further assist with efficient thermal management by the plate, particularly for cooling applications. Any combination or sub-combination of one or more fans and one or more power sources such as a photovoltaic cell can be used.

In further embodiments, a method of managing the temperature of a room comprises maintaining a temperature of the room between about -50°C and 50°C. In some cases, a method comprises maintaining a temperature of the room between about -10°C and 0°C, between about 0°C and 10°C, between about 17°C and 25°C, between about 20°C and 25°C, or between about 20°C and 30°C. A method described herein can also comprise maintaining the temperature of a room at a desired set-point temperature (or within 1°C, within 2°C, or within 3°C of the desired set-point temperature) or within a temperature range described above in Section I, including in Table 1.

In addition, a method described herein, in some cases, further comprises changing the phase of the phase change material of a plate or panel described herein (or plurality of plates or panels described herein) disposed in the room (e.g., the telecom shelter, data room, or data center, or a freezer or refrigeration room) from a first phase to a second phase by exposing the phase change material to an ambient temperature of the room above a phase change temperature of the phase change material (e.g., such as may be caused by the normal operation of telecommunications equipment or other electronic equipment or other sources of heat disposed in the room, or by heat exchange between the room and an external environment of the room that is warmer), and subsequently reverting the phase change material to the first phase by cooling the room with an HVAC system of the room. Further, in some embodiments, the HVAC system is activated or deactivated by a thermostat disposed within the interior of the room

Similarly, a method described herein can further comprises changing the phase of the thermal management material (such as a phase change material) of the plate or panel (or plurality of plates or panels) disposed in the room from a first phase to a second phase by exposing the phase change material to an ambient temperature in the room below a phase change temperature of the phase change material, and subsequently reverting the phase change material to the first phase by heating the room with an HVAC (heating, ventilation, and air conditioning) system of the room.

In another embodiment, a method of cooling or managing the temperature of a pallet or shipping container is described herein. The pallet or shipping container can be any pallet or container suitable for supporting or containing goods, especially, for the transport of goods. A method of cooling a pallet or container, in some cases, comprises providing one or more thermal management plates, as described above in Section I, and positioning the one or more plates in an interior space of the pallet or container. In some embodiments, the one or more plates are placed in the bottom of the pallet or container or along the walls of the pallet or container. One or more plates may also be placed on top of the goods placed on or inside the pallet or container.

It is further to be understood that the thermal management material (e.g., the PCM) placed inside a plate or panel can be selected based on a desired set point or maintenance temperature for the particular goods or products associated with the pallet or shipping container in a specific instance. For example, in some cases, a PCM having a phase transition temperature in the range of 20-25°C can be used for helping maintain the temperature of goods or products at a temperature in the range of range of 20-25°C. A method described herein can also comprise maintaining the temperature of goods or products within a pallet or shipping container at a temperature within other ranges described herein.

It should further be noted that, in some cases, the dimensions of a plate or panel are selected to match the dimensions of a pallet or shipping container, or to be an integral fraction of the dimensions of the pallet or shipping container. For instance, in some cases, a plate or panel has dimensions (particularly in the x and y dimensions) that are the same as the x and y dimensions of the bottom of the pallet or shipping container, or that are one-half or one-third or one-fourth of the a given dimension (e.g., the x dimension of the plate or panel may match the x dimension of the pallet or shipping container, while the y dimension of the plate or panel may be one-half of the y dimension of the pallet or shipping container, such that two plates or panels can be placed easily on or within the pallet or container, while covering all or substantially all of the desired surface of the pallet or container.

Various implementations of devices and methods have been described in fulfillment of various objectives of the present disclosure. It should be recognized that these implementations are merely illustrative of the principles of the present disclosure. Numerous modifications and adaptations thereof will be readily apparent to those skilled in the art within the scope of the invention as defined in the claims.

## Claims

1. A thermal management plate (100) comprising:
an exterior surface (101) defining an interior volume;
a phase change material disposed within the interior volume; and
a fill spout (110) in fluid communication with the interior volume and with an external environment of the plate,
wherein the exterior surface (101) includes a front side (102), a back side (103), and at least four corners (104); and
**characterized in that**
the fill spout (110) is disposed at one of the corners (104) of the exterior surface (101).

2. The plate (100) of claim 1, wherein:
the exterior surface (101) defines a hollow spine (201) on the front side (102) or the back side (103) of the plate (100), the spine (201) having one long dimension (d1) and two short dimensions (d2, d3) and an interior volume;
the average thickness of the spine (d2) along the long dimension of the spine (201) (d1) is 1.5 to 10 times the average thickness of the plate (100) overall;
the long dimension of the spine (201) (d1) extends diagonally from the fill spout (110) to a corner (104) of the plate opposite the fill spout (110);
the fill spout (110) is in fluid communication with the interior volume of the spine (201); and a fill direction of the fill spout (110) is aligned with the long dimension of the spine (201) (d1), or
wherein at least 97% of the interior volume is occupied by the phase change material.

3. The plate (100) of claim 1, wherein the exterior surface (101) further comprises one or more protrusions (108) extending in an orthogonal direction from the back side (103) of the plate, and optionally
wherein the one or more protrusions (108) is configured to form a gap (113) between the back side (103) of the plate and an adjacent surface.

4. The plate (100) of claim 1, wherein the exterior surface (101) further comprises one or more channels (109) extending from the front side (102) to the back side (103) and connecting the front side (102) to the back side (103).

5. The plate (100) of claim 1, wherein the plate further comprises a cap, and optionally
wherein the cap is a snap-on cap, or
wherein surfaces of the cap align with the exterior surface (101) to conceal the corner fill spout.

6. The plate (100) of claim 1, wherein the phase change material is present in an amount of 70-90 wt. %, based on the total weight of the plate (100), or
wherein the phase change material has a phase transition temperature between -50°C and 150°C.

7. The plate (100) of claim 1, wherein the plate further comprises a fan, and optionally
wherein the fan is positioned within a channel (109) extending from the front side (102) to the back side (103) of the plate (100) and connecting the front side (102) to the back side (103), and optionally
wherein the fan is solar powered or thermoelectrically powered.

8. The plate (100) of claim 1, wherein the front side (102) and the back side (103) have a total length of less than 40 inches and a total width of less than 80 inches.

9. The plate (100) of claim 1, wherein the front side (102) and the back side (103) have a total length between 12 and 24 inches and a total width between 20 and 40 inches, and optionally
wherein the depth of the plate (100) is less than 3 inches.

10. A method of managing the temperature of a room, the method comprising:
disposing one or more plates (100) of claim 1 in the room.

11. The method of claim 10, the method further comprising:
positioning the one or more plates (100) so the back surface of the one or more plates faces a wall of the room; and
suspending the one or more plates (100) from the wall, and optionally
wherein the one or more plates (100) are suspended from a mounting mechanism on the wall, and optionally
wherein the mounting mechanism comprises parallel rails.

12. The method of claim 10, wherein a plurality of plates (100) are disposed in the room and the plurality of plates (100) are positioned in a front-to-back orientation, or
wherein a plurality of plates are disposed in the room and the plurality of plates (100) are positioned in a side-by-side orientation, or
wherein the room is a data center, telecom shelter, or data storage room, or
wherein the room has a desired average temperature between 15°C and 30°C.

13. The method of claim 10, wherein the room is a refrigerated room or a freezer, and optionally
wherein the room has a desired average temperature between -10°C and 10°C.

14. The method of claim 10, the method further comprising:
changing the phase of the phase change material from a first phase to a second phase by exposing the phase change material to an ambient temperature of the room above a phase change temperature of the phase change material; and
reverting the phase change material to the first phase by cooling the room with an HVAC system of the room, and optionally
wherein the HVAC system is activated or deactivated by a thermostat disposed within the interior of the room.

15. A method of managing the temperature of a pallet, the method comprising:
positioning one or more plates (100) of claim 1 in an interior space of the pallet, and optionally
wherein the one or more plates (100) are positioned on a bottom of the interior space of the pallet, along the walls of the interior space of the pallet, and/or on top of contents disposed in the interior space of the pallet, and optionally
wherein the pallet has an average desired temperature between - 20°C and 30°C.

16. The thermal management plate (100) of claim 1, wherein the exterior surface is formed from a polymeric or plastic material, a metal or mixture or alloy of metals, or a composite material.

## Patentansprüche

1. Wärmeverwaltungsplatte (100), umfassend:
eine Außenfläche (101), die ein Innenvolumen definiert;
ein Phasenwechselmaterial, das innerhalb des Innenvolumens angeordnet ist; und
einen Füllstutzen (110) in Fluidkommunikation mit dem Innenvolumen und mit einer äußeren Umgebung der Platte,
wobei die Außenfläche (101) eine Vorderseite (102), eine Rückseite (103) und zumindest vier Ecken (104) beinhaltet; und
**dadurch gekennzeichnet, dass**
der Füllstutzen (110) an einer der Ecken (104) der Außenfläche (101) angeordnet ist.

2. Platte (100) nach Anspruch 1, wobei:
die Außenfläche (101) einen hohlen Rücken (201) an der Vorderseite (102) oder der Rückseite (103) der Platte (100) definiert, wobei der Rücken (201) eine lange Abmessung (d1) und zwei kurze Abmessungen (d2, d3) und ein Innenvolumen aufweist;
die durchschnittliche Dicke des Rückens (d2) entlang der langen Abmessung des Rückens (201) (d1) 1,5- bis 10-mal die durchschnittliche Dicke der Platte (100) insgesamt ist;
sich die lange Abmessung des Rückens (201) (d1) diagonal von dem Füllstutzen (110) zu einer Ecke (104) der Platte gegenüber dem Füllstutzen (110) erstreckt;
der Füllstutzen (110) in Fluidkommunikation mit dem Innenvolumen des Rückens (201) ist; und eine Füllrichtung des Füllstutzens (110) mit der langen Abmessung des Rückens (201) (d1) ausgerichtet ist, oder
wobei zumindest 97 % des Innenvolumens durch das Phasenwechselmaterial belegt sind.

3. Platte (100) nach Anspruch 1, wobei die Außenfläche (101) ferner einen oder mehrere Vorsprünge (108) umfasst, die sich in einer orthogonalen Richtung von der Rückseite (103) der Platte erstrecken, und optional
wobei der eine oder die mehreren Vorsprünge (108) konfiguriert sind, um einen Spalt (113) zwischen der Rückseite (103) der Platte und einer benachbarten Fläche zu bilden.

4. Platte (100) nach Anspruch 1, wobei die Außenfläche (101) ferner einen oder mehrere Kanäle (109) umfasst, die sich von der Vorderseite (102) zu der Rückseite (103) erstrecken und die Vorderseite (102) mit der Rückseite (103) verbinden.

5. Platte (100) nach Anspruch 1, wobei die Platte ferner eine Kappe umfasst, und optional
wobei die Kappe eine Schnappkappe ist, oder
wobei Flächen der Kappe mit der Außenfläche (101) ausgerichtet sind, um den Eckfüllstutzen zu verbergen.

6. Platte (100) nach Anspruch 1, wobei das Phasenwechselmaterial in einer Menge von 70-90 Gew.-% basierend auf dem Gesamtgewicht der Platte (100), vorhanden ist, oder
wobei das Phasenwechselmaterial eine Phasenübergangstemperatur zwischen -50 °C und 150 °C aufweist.

7. Platte (100) nach Anspruch 1, wobei die Platte ferner ein Gebläse umfasst, und optional
wobei das Gebläse innerhalb eines Kanals (109) angeordnet ist, der sich von der Vorderseite (102) zu der Rückseite (103) der Platte (100) erstreckt und die Vorderseite (102) mit der Rückseite (103) verbindet, und optional
wobei das Gebläse solarangetrieben oder thermoelektrisch angetrieben ist.

8. Platte (100) nach Anspruch 1, wobei die Vorderseite (102) und die Rückseite (103) eine Gesamtlänge von weniger als 40 Zoll und eine Gesamtbreite von weniger als 80 Zoll aufweisen.

9. Platte (100) nach Anspruch 1, wobei die Vorderseite (102) und die Rückseite (103) eine Gesamtlänge zwischen 12 und 24 Zoll und eine Gesamtbreite zwischen 20 und 40 Zoll aufweisen, und optional
wobei die Tiefe der Platte (100) weniger als 3 Zoll ist.

10. Verfahren zum Verwalten der Temperatur eines Raums, wobei das Verfahren Folgendes umfasst:
Anordnen von einer oder mehreren Platten (100) nach Anspruch 1 in dem Raum.

11. Verfahren nach Anspruch 10, wobei das Verfahren ferner Folgendes umfasst:
Positionieren der einen oder mehreren Platten (100), sodass die Rückfläche der einen oder mehreren Platten einer Wand des Raums zugewandt ist; und
Aufhängen der einen oder mehreren Platten (100) an der Wand, und optional
wobei die eine oder mehreren Platten (100) an einem Montagemechanismus an der Wand aufgehängt sind, und optional
wobei der Montagemechanismus parallele Schienen umfasst.

12. Verfahren nach Anspruch 10, wobei eine Vielzahl von Platten (100) in dem Raum angeordnet ist und die Vielzahl von Platten (100) in einer Ausrichtung von vorne nach hinten positioniert ist, oder
wobei eine Vielzahl von Platten in dem Raum angeordnet ist und die Vielzahl von Platten (100) in einer Seite-an-Seite-Ausrichtung positioniert ist, oder
wobei der Raum ein Rechenzentrum, eine Telekommunikationsunterkunft oder ein Datenspeicherraum ist, oder
wobei der Raum eine gewünschte Durchschnittstemperatur zwischen 15 °C und 30 °C aufweist.

13. Verfahren nach Anspruch 10, wobei der Raum ein Kühlraum oder ein Gefrierschrank ist, und optional
wobei der Raum eine gewünschte Durchschnittstemperatur zwischen -10 °C und 10 °C aufweist.

14. Verfahren nach Anspruch 10, wobei das Verfahren ferner Folgendes umfasst:
Wechseln der Phase des Phasenwechselmaterials von einer ersten Phase zu einer zweiten Phase, indem das Phasenwechselmaterial einer Umgebungstemperatur des Raums über einer Phasenwechseltemperatur des Phasenwechselmaterials ausgesetzt wird; und
Rückführen des Phasenwechselmaterials zu der ersten Phase durch Kühlen des Raums mit einem HVAC-System des Raums, und optional
wobei das HVAC-System durch einen Thermostat, der innerhalb des Inneren des Raums angeordnet ist, aktiviert oder deaktiviert wird.

15. Verfahren zum Verwalten der Temperatur einer Palette, wobei das Verfahren Folgendes umfasst:
Positionieren von einer oder mehreren Platten (100) nach Anspruch 1 in einem Innenraum der Palette, und optional
wobei die eine oder mehreren Platten (100) auf einem Boden des Innenraums der Palette, entlang der Wände des Innenraums der Palette und/oder auf Inhalten, die in dem Innenraum der Palette angeordnet sind, positioniert sind, und optional
wobei die Palette eine durchschnittliche gewünschte Temperatur zwischen - 20 °C und 30 °C aufweist.

16. Wärmeverwaltungsplatte (100) nach Anspruch 1, wobei die Außenfläche aus einem Polymer- oder Kunststoffmaterial, einem Metall oder Gemisch oder Legierung von Metallen oder einem Verbundmaterial gebildet ist.

## Revendications

1. Plaque de gestion thermique (100) comprenant :
une surface extérieure (101) définissant un volume intérieur ;
un matériau à changement de phase disposé à l'intérieur du volume intérieur ; et
un bec de remplissage (110) en communication fluidique avec le volume intérieur et avec un environnement externe de la plaque,
dans laquelle la surface extérieure (101) comprend un côté avant (102), un côté arrière (103) et au moins quatre coins (104) ; et
**caractérisé en ce que** le bec de remplissage (110) est disposé à l'un des coins (104) de la surface extérieure (101).

2. Plaque (100) selon la revendication 1, dans laquelle :
la surface extérieure (101) définit une arête creuse (201) sur le côté avant (102) ou le côté arrière (103) de la plaque (100), l'arête (201) ayant une dimension longue (d1) et deux dimensions courtes (d2, d3) et un volume intérieur ;
l'épaisseur moyenne de l'arête (d2) le long de la dimension longue de l'arête (201) (d1) est 1,5 à 10 fois l'épaisseur moyenne de la plaque (100) globalement ;
la dimension longue de l'arête (201) (d1) s'étend en diagonale depuis le bec de remplissage (110) jusqu'à un coin (104) de la plaque opposé au bec de remplissage (110) ;
le bec de remplissage (110) est en communication fluidique avec le volume intérieur de l'arête (201) ; et une direction de remplissage du bec de remplissage (110) est alignée à la dimension longue de l'arête (201) (d1), ou
dans laquelle au moins 97 % du volume intérieur est occupé par le matériau à changement de phase.

3. Plaque (100) selon la revendication 1, dans laquelle la surface extérieure (101) comprend en outre une ou plusieurs protubérances (108) s'étendant dans une direction orthogonale depuis le côté arrière (103) de la plaque, et éventuellement
dans laquelle l'une ou plusieurs protubérances (108) sont configurées pour former un espace (113) entre le côté arrière (103) de la plaque et une surface adjacente.

4. Plaque (100) selon la revendication 1, dans laquelle la surface extérieure (101) comprend en outre un ou plusieurs canaux (109) s'étendant du côté avant (102) au côté arrière (103) et reliant le côté avant (102) au côté arrière (103).

5. Plaque (100) selon la revendication 1, dans laquelle la plaque comprend en outre un capuchon, et éventuellement
dans laquelle le capuchon est un capuchon encliquetable, ou
dans laquelle les surfaces du capuchon s'alignent à la surface extérieure (101) pour cacher le bec de remplissage de coin.

6. Plaque (100) selon la revendication 1, dans laquelle le matériau à changement de phase est présent en une quantité de 70 à 90 % en poids, sur la base du poids total de la plaque (100), ou
dans laquelle le matériau à changement de phase a une température de transition de phase comprise entre -50 °C et 150 °C.

7. Plaque (100) selon la revendication 1, dans laquelle la plaque comprend en outre un ventilateur, et éventuellement
dans laquelle le ventilateur est positionné dans un canal (109) s'étendant du côté avant (102) au côté arrière (103) de la plaque (100) et reliant le côté avant (102) au côté arrière (103), et éventuellement
dans laquelle le ventilateur est alimenté par l'énergie solaire ou thermoélectrique.

8. Plaque (100) selon la revendication 1, dans laquelle le côté avant (102) et le côté arrière (103) ont une longueur totale inférieure à 40 pouces et une largeur totale inférieure à 80 pouces.

9. Plaque (100) selon la revendication 1, dans laquelle le côté avant (102) et le côté arrière (103) ont une longueur totale comprise entre 12 et 24 pouces et une largeur totale comprise entre 20 et 40 pouces, et éventuellement
dans laquelle la profondeur de la plaque (100) est inférieure à 3 pouces.

10. Procédé de gestion de la température d'une pièce, le procédé comprenant : la disposition d'une ou plusieurs plaques (100) selon la revendication 1 dans la pièce.

11. Procédé selon la revendication 10, le procédé comprenant en outre :
le positionnement de l'une ou plusieurs plaques (100) de sorte que la surface arrière de l'une ou plusieurs plaques fasse face à un mur de la pièce ; et
la suspension de l'une ou plusieurs plaques (100) au mur, et éventuellement
dans lequel l'une ou plusieurs plaques (100) sont suspendues à un mécanisme de montage au mur, et éventuellement
dans lequel le mécanisme de montage comprend des rails parallèles.

12. Procédé selon la revendication 10, dans lequel une pluralité de plaques (100) sont disposées dans la pièce et la pluralité de plaques (100) sont positionnées dans une orientation avant-arrière, ou
dans lequel une pluralité de plaques sont disposées dans la pièce et la pluralité de plaques (100) sont positionnées dans une orientation côte à côte, ou
dans lequel la pièce est un centre de données, un abri de télécommunications ou une salle de stockage de données, ou
dans lequel la pièce a une température moyenne souhaitée comprise entre 15 °C et 30 °C.

13. Procédé selon la revendication 10, dans lequel la pièce est une pièce réfrigérée ou un congélateur, et éventuellement
dans lequel la pièce a une température moyenne souhaitée comprise entre -10 °C et 10 °C.

14. Procédé selon la revendication 10, le procédé comprenant en outre :
le changement de la phase du matériau à changement de phase d'une première phase à une seconde phase en exposant le matériau à changement de phase à une température ambiante de la pièce supérieure à une température de changement de phase du matériau à changement de phase ; et
l'inversion du matériau à changement de phase à la première phase en refroidissant la pièce avec un système CVC de la pièce, et éventuellement
dans lequel le système CVC est activé ou désactivé par un thermostat disposé à l'intérieur de la pièce.

15. Procédé de gestion de la température d'une palette, le procédé comprenant :
le positionnement d'une ou plusieurs plaques (100) selon la revendication 1 dans un espace intérieur de la palette, et éventuellement
dans lequel l'une ou plusieurs plaques (100) sont positionnées sur un fond de l'espace intérieur de la palette, le long des murs de l'espace intérieur de la palette, et/ou sur le dessus du contenu disposé dans l'espace intérieur de la palette, et éventuellement
dans lequel la palette a une température moyenne souhaitée comprise entre -20 °C et 30 °C.

16. Plaque de gestion thermique (100) selon la revendication 1, dans laquelle la surface extérieure est formée d'un matériau polymère ou plastique, d'un métal ou d'un mélange ou d'un alliage de métaux, ou d'un matériau composite.
